# EUROPEAN PATENT APPLICATION

(11) **EP 4 738 364 A1**
(43) Date of publication of application: **06.05.2026**
(21) Application number: 25210352.8
(22) Date of filing: 22.10.2025
(51) Int. Cl.: G11C 11/56, G06F 11/10, G11C 29/42, G11C 29/52, G11C 16/28, G11C 16/26

(54) **NON-VOLATILE MEMORY WITH ERROR CORRECTION**

(30) Priority: 31.10.2024 US 202418932919
(71) Applicant: NXP B.V., 5656 AG Eindhoven (NL)
(72) Inventor: Storms, Maurits Mario Nicolaas, 5656AG Eindhoven (NL); Rebollo Pimentel, Ivan Jesus, 5656AG Eindhoven (NL); Zachariasse, Frank, 5656AG Eindhoven (NL); van Straaten, Bram, 5656AG Eindhoven (NL); de Meulmeester, Jacobus, 5656AG Eindhoven (NL)
(74) Representative: Krott, Michel

(57) **Abstract**

In a non-volatile memory (NVM), a memory array has a differential bit cell at each row and column intersection, in which each row stores an N-bit data element and a single parity bit corresponding to the data element. Each differential bit cell includes a first and a second single-ended bit cell, and a logic state is determined by the logic states of the first and second single-ended bit cells. A read operation includes providing, from the differential bit cells of the selected row, differential read data having an N-bit data value and a corresponding single bit parity value, and providing logic states of each of the first and second single-ended bit cells of the differential bit cells of the selected row. Based on the logic states of the first and second single-ended bit cells, a read event flag and a multiple event flag are generated for the read operation.

## Description

### Background

### Field

This disclosure relates generally to memories, and more specifically, to a non-volatile memory with error correction.

### Related Art

Error correction (ECC) is a known technique used to enhance data retention in non-volatile memories (NVMs). To implement ECC, multiple error correction bits are stored with each data element in the memory array, in which the number of required error correction bits depends on the length of the data element. For example, with conventional single error correction double error detection (SECDED) ECC, 6 correction bits are needed for each 16-bit word. These multiple correction bits result for each data element in increased area overhead for the NVM as well as increased digital processing for performing ECC. Therefore, a need exists for improved ECC in NVMs with reduced impact on area overhead and ECC processing.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in block diagram form, an NVM memory having a memory array of differential bit cells and corresponding read circuitry, in accordance with one embodiment of the present invention.
FIG. 2 illustrates, in schematic form, a differential bit cell of the memory array of FIG. 1, in accordance with one embodiment of the present invention.
FIG. 3 illustrates, in partial block diagram and partial schematic form, a portion of the read circuitry of FIG. 1, in accordance with one embodiment of the present invention.
FIG. 4 illustrates, in diagrammatic form, a row of the memory array of FIG. 1 and a portion of the corresponding read circuitry, in accordance with one embodiment of the present invention.

### Detailed Description

In one aspect, an NVM is provided with SECDED ECC capability, but without requiring the multiple correction bits of traditional ECC for each data element. In this manner, reduced area overhead of the NVM is achieved, as compared to conventional NVMs. The memory array of the NVM is constructed as an array of differential bit cells, in which each differential bit cell is formed by two single-ended bit cells, in which each single-ended bit cell includes a storage element (such as a charge-based storage element implanted as a floating gate transistor). Each read operation from the NVM reads an addressed data element from the differential array, in which each read operation performs both differential reads and single-ended reads. For example, read circuitry coupled to the memory array is configured to provide differential read data from a set of addressed differential bit cells of the array during each read operation, in which each differential bit cell provides one bit of read data. The differential read data also includes a single parity bit, regardless of the length of the addressed data element. During each read operation, the read circuitry is further configured to provide single-ended read data from each of the single-ended cells of the set of addressed differential bit cells. ECC circuitry is configured to use the single-ended read data to detect and indicate a single bit error or multiple bit error for the read operation and to correct a single bit error, if possible. In this manner, an NVM with ECC is provided with reduced area overhead and reduced complexity.

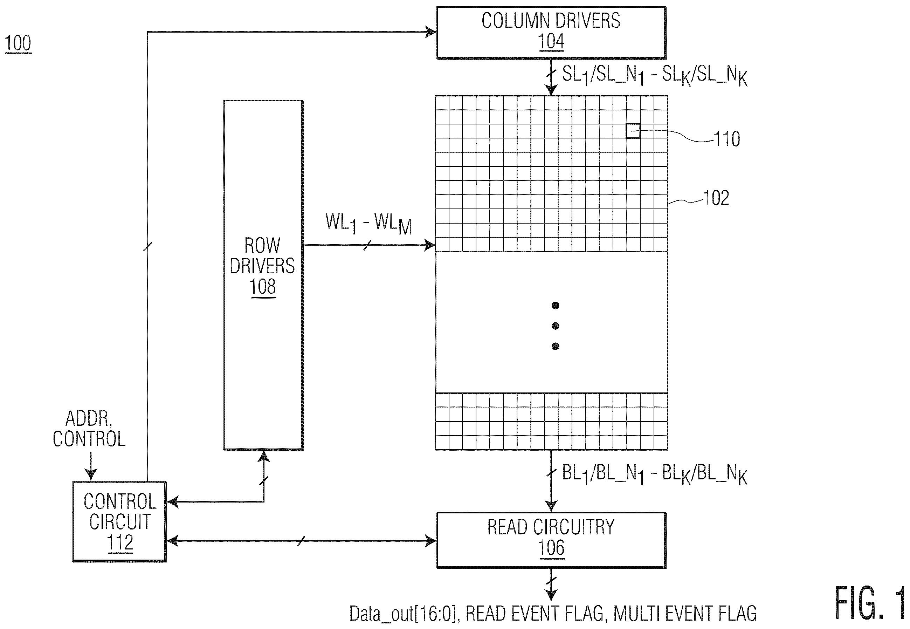

FIG. 1 illustrates, in block diagram form, an NVM 100, in accordance with an embodiment of the present invention. NVM 100 includes a memory array 102, column drivers 104, read circuitry 106, row drivers 108, and control circuitry 112. Array 102 is arranged in rows and columns, in which a differential bit cell (e.g. differential bit cell 110) is located at the intersection of each row and column. Array 102 includes M rows and K columns, and thus includes M x K differential bit cells. Each of M and K can be any integer value. In one embodiment, K is 17 (corresponding to a 16-bit data element and a single parity bit, as will be described in more detail below). Each row has a corresponding word line (WL₁-WL_{M}) and each column has an corresponding bit line (BL) pair (BL₁/BL_N₁ - BL_{K}/BL_N_{K}). In the illustrated embodiment, each column also includes a corresponding source line (SL) pair (SL₁/SL_N₁ - SL_{K}/SL_N_{K}), and each row also includes a control gate line (CGL₁-CGL_{M}). Note that for each bit line pair, BL_N corresponds to the complementary bit line (or inverse bit line) to BL, and similarly, for each source line pair, SL_N corresponds to the complementary source line (or inverse source line) of SL. Row drivers 108 are configured to drive the WLs and CGLs, and column drivers 104 are configured to drive the BL pairs and SL pairs. Each differential bit cell is therefore coupled to a corresponding WL, CGL, BL pair, and SL pair. Control circuitry 112 is coupled to row drivers 108, column drivers 104, and read circuitry 106, and receives memory access requests, each including an access address (ADDR) and corresponding control signals (such as a read/write (R/W) signal). Although not illustrated, control circuitry 112 also receives write data for write access requests.

For a read access request, array 102 read circuitry returns read data stored in the differential bit cells located at the corresponding access address. Therefore, in response to a read access request, control 112 provides all or a portion of the corresponding access address to row drivers 108 to drive (i.e. activate) a selected word line. In doing so, row drivers 108 also drive the corresponding control gate line. In the illustrated embodiment, column drivers 104 are configured to appropriately precharge the BLs and BL_Ns to a predetermined voltage prior to each read operation. In this manner, in response to the read access request, read circuitry 106 outputs read data stored at the differential bit cells coupled to the selected word line.

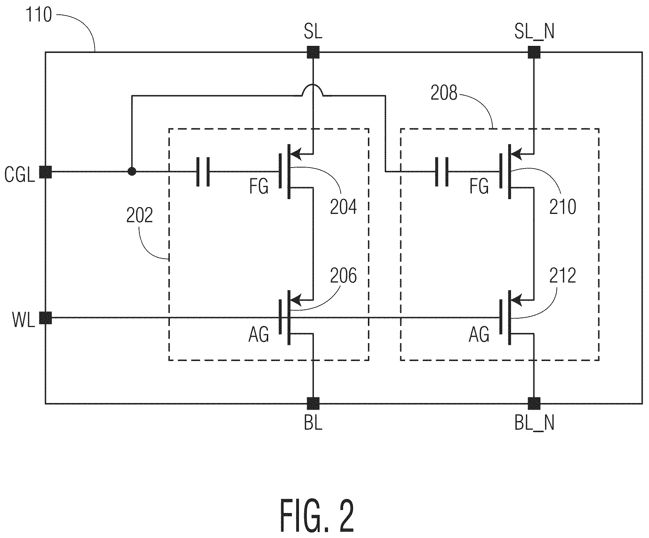

FIG. 2 illustrates, in schematic form, differential bit cell 110 of array 102 in further detail, in accordance with one embodiment of the present invention. (Note that all the differential bit cells of array 102 have the same structure as differential bit cell 110.) Differential bit cell 110 is formed from two single-ended cells: a left single-ended cell 202 (also referred to as a left cell) and a right single-ended cell 208 (also referred to as a right cell). Note that left and right are arbitrary labels provided to each of the single-ended cells, for ease of discussion. In the illustrated embodiment, each single-ended cell of differential bit cell 110 includes a charge-based storage element (e.g. 204, 210) and an access transistor (e.g. 206, 212). In the illustrated embodiment, the charge-based storage element is constructed with a single floating gate transistor whose floating gate forms a capacitor, illustrated as a capacitor coupled to the floating gate (FG) of the floating gate transistor, which can either be positively or negatively charged. Note that a positively charged charge-storage element corresponds to a first stored logic state and a negatively charged charge-storage element corresponds to a second stored logic state, opposite the first stored logic state. In the discussions herein, it will be assumed that positively charged corresponds to storing a "1" and negatively charged corresponds to storing a "0", however, this may be reversed in alternate embodiments. While NVM 100 can be a charge-based memory in which the first and second single-ended cells are implemented with charge-based storage elements, alternate embodiments may use different types of storage elements, therefore, the charge-based storage elements (e.g. 204, 210) may simply be referred to as storage elements. That is, NVM 100 can be any type of non-volatile memory, such as any NVM whose memory cells exhibit decreasing separation between stored states over time. For example, NVM 100 may be implemented as a magneto-resistive random access memory (MRAM), a resistive random access memory (RRAM), a phase change memory (PCM), etc.

As illustrated in FIG. 2, differential cell 110 is coupled to a corresponding WL, corresponding CGL, corresponding bit line pair BL/BL_N, and corresponding source line pair SL/SL_N. WL and CGL correspond to one of WL1-M and a corresponding one of CGL1-M, respectively. BL/BL_N and SL/SL_N correspond to one of BL₁/BL_N₁ - BL_{K}/BL_N_{K} and a corresponding one of SL₁/SL_N₁ - SL_{K}/SL_N_{K}, respectively. Left cell 202 includes charge storage element 204 and access transistor 206. Floating gate transistor 204 has a first current electrode (e.g. source electrode) coupled to SL, and a second current electrode (e.g. drain electrode) coupled to a first current electrode (e.g. source electrode) of access transistor 206. A second current electrode of access transistor 206 is coupled to BL, and a control electrode (e.g. access gate (AG)) of access transistor 206 is coupled to WL. The FG of floating gate transistor 204 is coupled via a capacitor to CGL (in which, as described above, the capacitor represents the capacitor provided by the FG). Right cell 208 includes charge storage element 210 (which can be referred to as floating gate transistor 210) and access transistor 212. Floating gate transistor 210 has a first current electrode (e.g. source electrode) coupled to SL_N, and a second current electrode (e.g. drain electrode) coupled to a first current electrode (e.g. source electrode) of access transistor 212. A second current electrode of access transistor 212 is coupled to BL_N, and a control electrode (e.g. AG) of access transistor 212 is coupled to WL. The FG of floating gate transistor 210 is coupled via a capacitor to CGL (in which, as described above, the capacitor represents the capacitor provided by the FG).

In operation, when differential bit cell 110 is accessed for a read operation such that WL and BL are selected by the corresponding access address, WL is activated so as to turn on the access transistors (e.g. 206, 212) of the selected row and thus allow the charge storage elements (e.g. 204, 210) to affect the voltages on BL/SL and BL_N/SL_N, respectively (in which, in one embodiment, the SLs are all set to a fixed voltage). In one embodiment, the BLs are all precharged to predetermined level prior to the read operation, and, depending on how the charge elements are charged (i.e. depending on the logic state of the left and right cells), either BL or BL_N will be pulled up high while the other will stay low. Based on the comparison between BL and BL_N, the corresponding bit of the output differential read value will be a one or zero. Table 1 below indicates the possible logic states of each of the left and right (single-ended) cells, and the resulting logic state of the differential cell.

**Table 1**

| **Differential Cell** | **Left** | **Right** | **Comments** |
|---|---|---|---|
| 1 | 1 | 0 | Valid Data |
| 0 | 0 | 1 | Valid Data |
| X | 1 | 1 | Invalid Data |
| X | 0 | 0 | Invalid Data |

The top two rows of the above table represent valid data stored in the differential bit cell. Using differential bit cell 110 as an example, if the left cell stores a 1 and the right cell stores a 0, then the stored value of the differential bit cell corresponds to a 1. On the other hand, if the right cell stores a 1 and the left cell a 0, then the stored value of the differential bit cell corresponds to a 0. The bottom two rows represent invalid data because, for a differential bit cell, the two single-ended cells of the differential bit cell should not store the same state. For example, if both the charged elements of the left and right cell are positively charged or both are negatively charged, then something incorrect occurred. For example, there may have been an error caused by incorrect program/erase of the left and right cells, or there may have been retention loss in one or both of the left and right cells.

Note that it is known in the art how to program and erase charge-based storage elements of the left and right cells, so the details of program and erase are not provided herein. Also, note that the particular architecture of the differential bit cell implemented with two single-ended cells of FIG. 2 is only provided as an example. That is, in alternate embodiments, a differential bit cell can be designed with two single-ended cells using a different architecture, such as by using different storage elements for the single-ended cells, using more or fewer transistors to properly access the single-ended cells, etc. Read circuitry 106, in order to read the selected (i.e. addressed) differential cells, includes a set of differential read-out circuits coupled to each columns (e.g. to each BL/BL_N pair) of array 102 so as to determine a stored value of each differential bit cell. Any known circuitry, such as a sense amplifier or comparator can be implemented to determine which of BL or BL_N has a higher voltage so as to determine the bit value stored in the differential bit cell.

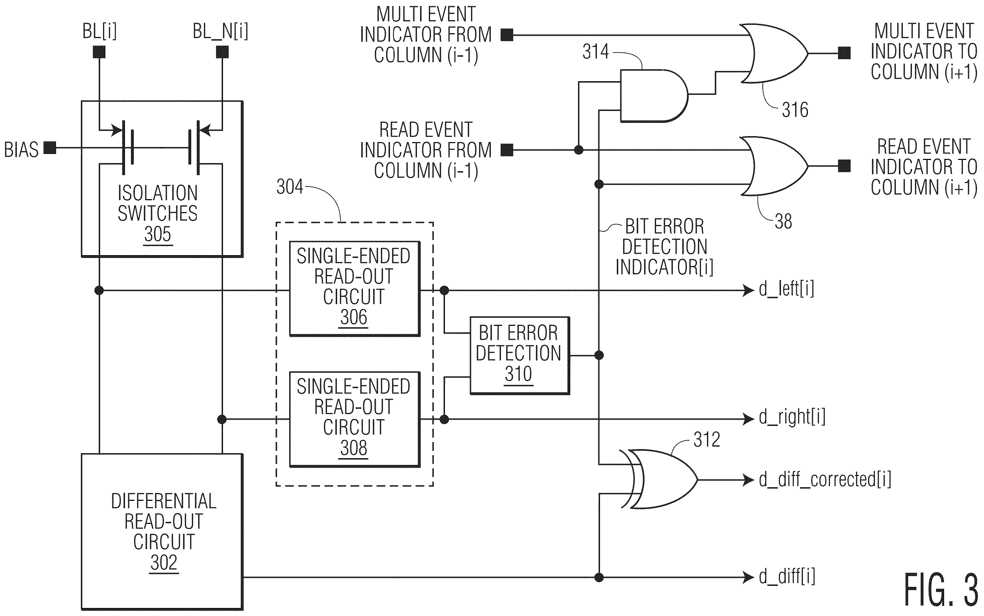

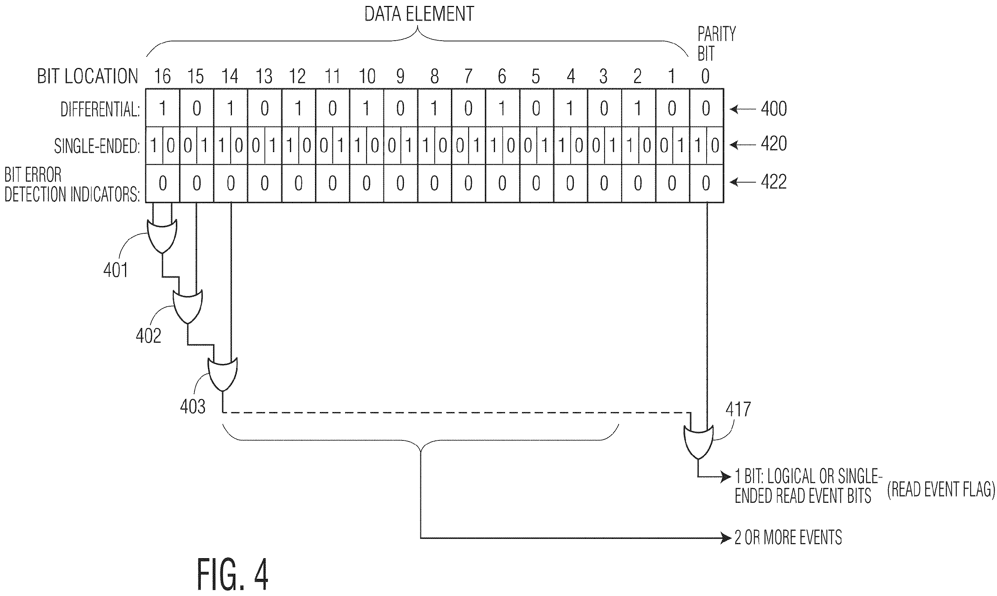

FIG. 3 illustrates, in partial block diagram and partial schematic form, a more detailed view of read circuitry 106, in accordance with one embodiment of the present invention. FIG. 4 illustrates, in diagrammatic form, an example programmed row 400 of array 102, in accordance with an embodiment of the present invention, in which bit locations of the differential bits of row 400 are provided across the top of row 400 (e.g. bit location 16 down to bit location 0). The row of FIG. 4 can represent any row of array 102, such as the row containing differential bit 110. In one embodiment, each row of array 102 is configured to store a 16-bit data element and a single parity bit corresponding to the 16-bit data element, in which each bit of the 16-bit data element as well as the single parity bit are implemented with a differential bit cell. Therefore, a read to row 400, in response to a read access request, obtains 17 bits of differential read data, including the 16-bit data element and the corresponding parity bit. Row 400 represents the differential data (d_diff) for bit 16 down to bit 1 (corresponding to d_diff[16:1]), followed by the corresponding differential parity bit (corresponding to d_diff[0]). Each differential bit has a value of 1 or 0 (in which the values provided in the first row of row 400 are merely example stored data values). In one embodiment, the corresponding parity bit is set to a 1 if the 16-bit data element includes an odd number of zeros, and to a 1 otherwise. Therefore, in the illustrated embodiment, the parity bit of row 400 is 0 because d_diff[16:1] includes an even number of zeros.

Still referring to FIG. 4, two lines of additional information are provided with respect to row 400, lines 420 and 422. Line 420 represents the single-ended data of row 400, in which each differential data bit of row 400 is formed by two corresponding single-ended data bits. For example, d_diff[i] (corresponding to the i-th bit of d_diff[16:0]) is formed by two single-ended bits, one stored in the left cell and the other in the right cell, as was described above. These can be referred to as d_left[i] and d_right[i]. Therefore, the 16-bit differential data element plus the differential parity bit are stored as 17x2 (=34) single-ended bits. Note that as part of a read operation to row 400 in response to a read request to obtain the 17 bits of differential read data, read circuitry 106 also accesses the values of each of the single-ended cells to obtain 34 bits of single-ended read data. Although the accessible data element for a read access is described as being 16-bits, in alternate embodiments, the accessible data element can be any size, depending on the design of memory 100. For example, it can be any N-bit data element in which N is a positive integer greater than one, but regardless of the size of the accessible data element, only a single parity bit needs to be stored with each data element. Note that, for a read operation, an N-bit data element results in (N+1) bits of differential read data and (N+1)x2 bits of single-ended read data.

Referring to FIG. 3, a portion of read circuitry 106 corresponding to an i-th column of array 102 is illustrated which generates d_diff, d_right, d_left, a bit error detection indicator, a read event indicator, and a multi event indicator with respect to the i-th differential bit of the accessed row. Therefore, references to d_diff, d_right, d_left, bit error detection indicator, read event indicator, and multi event indicator in FIG. 3 refer to d_diff[i], d_right[i], d_left[i], bit error detection indicator[i], read event indicator[i], and a multi event indicator[i], respectively.

As described above, read circuitry 106 includes a differential read-out circuit and a set of isolation switches for each column of array 102. Therefore, as illustrated in FIG. 3, a differential read-out circuit 302 is coupled, via a set of isolation switches 305, to the bit line pair of the i-th column (BL[i]/BL_N[i]). Isolation switches 305 are enabled during a read access to memory array 102 such that, during the read, the isolation switches 305 are turned on in order to connect BL[i] and BL_N[i] to differential read-out circuit 302 (and to isolate the bit line pair from read-out circuit 302 otherwise, such as during writes). As described above, during a read operation, the circuitry of differential read-out circuit generates d_diff[i] based on which bit line of the bit line pair is pulled up, so as to operate in accordance with the first two rows of Table 1 above. In one embodiment, regardless of what is sensed on the bit line pair (i.e. even if there is a problem with either of the single-ended cells), differential read-out circuit 302 will always make a decision as to whether to output a 1 or 0 for d_diff[i].

The portion of read circuitry 106 corresponding to the i-th column also includes single-ended read-out circuitry 304, a bit error detection circuit 310, and digital logic including an AND gate 314, OR gates 316 and 318, and an XOR gate 312. Single-ended read-out circuitry 304 includes a single-ended read-out circuit 306 coupled to BL[i], which is connected to the left cell of the i-th differential bit cell, and a single-ended read-out circuit 308 coupled to BL_N[i], which is connected to the right cell of the i-th differential bit cell. Each of the single-ended read-out circuits outputs the logic state stored by the corresponding single-ended cell of the i-th differential cell. For example, single-ended read-out circuit 306 provides the logic state (1 or 0) stored by the left cell as d_left[i], and single-ended read-out circuit 308 provides the logic state (1 or 0) stored by the right cell as d_right[i]. The single-ended read-out circuits 306 and 308 can be implemented with any known circuit, such as, for example, with a sense amplifier, an inverter, or a gated inverter.

If a bit value is properly stored in the differential bit, then d_left and d_right should be different (have opposite logic states). Therefore, bit error detection circuit 310 receives each of d_left and d_right and asserts its output (a bit error detection indicator[i]) to a logic level 1 if both d_left and d_right are the same to indicate a bit error in the differential bit cell. If d_left and d_right do not match, then bit error detection indicator[i] is negated to a logic level zero. In one embodiment, it is presumed that both d_left and d_right being a logic level one does not occur (or at least does not indicate an error). That is, the condition in which both are a logic level one, if it does occur, is unlikely to impact the differential readout, thus not indicating an error. Therefore, in this embodiment, a bit error is indicated only when d_left and d_right are both zero, and otherwise, no bit error is indicated. In this embodiment, bit error detection circuit 310 can be implemented as a NOR gate having d_left and d_right as inputs and the bit error detection indicator provided as an output of the NOR gate. Referring back to FIG. 4, line 422 corresponds to the outputs of the NOR gates, which correspond to the bit error detection indicator of each column. In alternate embodiments, bit error detection circuit 310 can be implemented with a different logic gate or combination of gates. For example, in an embodiment in which both d_left and d_right being one also indicates an error, an XNOR gate can instead be used. Note that the bit errors detected by the assertion of a corresponding bit error detection indicator correspond to detected read events (each resulting, e.g., from an error in a single-ended cell).

With each read access to array 102, read circuitry 106 generates a one-bit read event flag and a one-bit multi event flag with combinatorial logic When asserted to a logic level one, the read event flag indicates that at least one single-ended cell error was detected in the read access, and the multi event flag indicates that more than one read event was detected in the read access. Otherwise, the flags are negated to logic level zeros. These two flags are generated for each read access, in which their final values are each generated based on information obtained from all the columns.

For example, for the i-th column, as illustrated in FIG. 3, OR gate 318 receives, at a first input, a read event indicator from a previous column i-1, and receives, at a second input, bit error detection indicator[i] (i.e. the output of bit error detection 310), and provides its output as read event indicator[i] to a next column i+1. Note that, if the i-th column is the first column of array 102 (corresponding to bit location 16), then the first input of OR gate 318 can be tied to zero or the first and second inputs of OR gate 318 can be tied together. Therefore, referring back to FIG. 4, OR gate 401 corresponds to OR gate 318 of the first column of array 102, in which both inputs are tied together (asserting read event indicator[16] at the output of OR gate 401 for the first column if bit error detection indicator[16] is asserted to a one). OR gate 402 corresponds to OR gate 318 of the 2^{nd} column of array 102 (corresponding to bit location 15), which receives at its first input, the read event indicator from the previous column (read event indicator [16], corresponding to the output of OR gate 401) and receives at its second input, the output from bit detection error 310 of the 2^{nd} column (bit error detection indicator [15]). OR gate 402 therefore provides read event indicator[15]. Similarly, OR gate 403 corresponds to OR gate 318 of the 3^{rd} column of array 102, which receives at its first input, the read event indicator from the previous column (read event indicator [15], corresponding to the output of OR gate 402) and receives at its second input, the output from bit detection error 310 of the 3^{rd} column (bit error detection indicator [14]). OR gate 403 therefore provides read event indicator[14]. Therefore, each column has a corresponding OR gate which provides the corresponding read event indicator[i], in which an output of OR gate 417 (corresponding to the 17^{th} column of array 102 which stores the parity differential bit) provides read event indicator[0] as the final value of the read event flag. That is, the read event flag represents the logical ORing of the single-ended read event indicators of all the columns, and indicates whether at least one read event has been detected.

Referring back to FIG. 3, an OR gate 316 has a first input which is coupled to receive a multi event indicator from the previous column i-1 and a second input coupled to an output of an AND gate 314. AND gate 314 has a first input which receives the read event indicator from the previous column i-1 and a second input which receives bit error detection indicator[i] from bit error detection 310. Note that if the output of AND gate 314 is asserted to a logic level one, at least two read single-ended read errors are indicated since bit error detection indicator[i] is asserted to a logic level one and the read event indicator[i-1] is also asserted to a logic level one. If the output of AND gate 314 is a one, or the multi event indicator from the previous columns is a one, then multi event flag indicator[i] at the output of OR gate 316 is also asserted to a one. Therefore, similar to the read event indicator, OR gate 316 of the last column provides multi event indicator[17] as the final value of the multi event flag, which indicates whether more than one read event has been detected.

Read circuitry 106 also includes XOR gate 312 which has a first input coupled to receive bit error detection indicator[i] and a second input coupled to receive d_diff[i], and outputs a corrected differential bit value (d_diff_corrected[i]). In this case, if bit error detection indicator[i] is a one, indicating an error in the single-ended reads, the value of d_diff[i] is switched to the opposite logic state to correct for the detected error. Therefore, in one embodiment, d_diff[16:0] corresponds to the raw (uncorrected) sensed differential read data from the accessed row while d_diff_corrected[16:0] corresponds to the corrected differential read data, each including 16 bits of data for the accessed data element and one parity bit.

In one embodiment, for each read access, selection circuitry corresponding to each column of array 102 (such as a multiplexer) may be used to determine which values to provide as data_out[16:0] by read circuitry 106. In addition to data_out[16:0], though, read circuitry 106 also provides the read event flag and multi event flag. Therefore, in the illustrated embodiment, a read bus requires a width of only 19 bits (16 bits for the data element, one for the parity bit, and two bits for the flags). Note that, in one embodiment, the read data returned to a requestor in response to a read access request is data_out[16:1], in which the parity bit is only used internally by read circuitry 106.

Therefore, the use of the parity bit, read event flag, and multi event flag can be used for each read access to determine further processing. For example, Table 2 below illustrates a truth table using the parity result and flags to determine a corresponding digital action, in accordance with an embodiment of the present invention. The parity result can be determined by read circuitry 106 in which read circuitry 106 may include a parity calculator to determine whether a count of the number of zeros in data_out[16:1] is odd or even and to determine if the resulting odd or even determination matches the parity bit (data_out[0]). For example, if the parity bit indicates an odd number of zeros, and data_out[16:1] has an odd number of zeros, the parity result is TRUE (indicating no parity error), but if data_out[16:1] has an even number of zeros, the parity result is FALSE, indicating a parity error. Note that in alternate embodiments, as described above, the parity calculation and parity bit may be made based on the number of ones rather than zeros. In the table below, the first three rows correspond to a read access having no parity error, while the last three rows correspond to having a parity error.

**Table 2**

| **Parity Result** | **Read Event Flag** | **Multi Event Flag** | **Result** | **Digital Action** |
|---|---|---|---|---|
| TRUE | 0 | 0 | No bit error | Do nothing (correction not required) |
| TRUE | 1 | 0 | Single-bit error | Do nothing (correction not required) |
| TRUE | 1 | 1 | Multi-bit error | Do nothing (correction not possible) |
| FALSE | 0 | 0 | Multi-bit error | Do nothing (correction not possible) |
| FALSE | 1 | 0 | Single-bit error | Select corrected data (1-bit corrected) |
| FALSE | 1 | 1 | Multi-bit error | Do nothing (correction not possible) |

In Table 2, the "do nothing" may refer to selecting the output as is, without correction (e.g. by selecting d_diff[16:0] as data out), while "select corrected data" may refer to selecting d_diff_corrected[16:0] as data out. The first row above corresponds to no errors in the read data since both the read and multi even flags are 0. Therefore, no correction is required. The second row, though, includes a single bit error (as indicated by the read event flag), but the d_diff[16:0] was still properly sensed (because the parity result is TRUE). Therefore, in this case, nothing more needs to be done. In the third row, though, it is also known that there were 2 or more bits in error (e.g. a multi-bit error) due to assertion of the multi event flag. In this case, since it is a multi-bit error, correction is not possible. Therefore, while nothing may be done (in which d_diff[16:0] is selected as data out), an alert may be provided to the system to indicate occurrence of the multi-bit error.

In the fourth row, since the parity result is FALSE but there was no single-bit error detected, no correction is possible. In the fifth row, although the parity result is FALSE, only a single-bit error was detected (since the multi event flag is 0), and this is correctable. Therefore, d_diff_corrected[16:0] (instead of d_diff[16:0]) can be selected as data out (in which, for this selected output, only the one bit of the 17 bits needing correction has been corrected). In the sixth row, though, since the multievent flag is 1, correction is also not possible. Note that Table 2 is not an exhaustive list of all actions which may be performed using the parity results and flags. Alternate embodiments may take fewer, additional, or different actions. Also, note that, as described above, in one embodiment, only data_out[16:1] (without the parity bit) is returned as read data to the requestor in response to a read access request. In one embodiment, the flags may also be provided by read circuitry 106 to other circuitry of a system on chip (SoC) containing memory 100, such as a fault collection unit. Note also that the circuitry of read circuitry 106 which generates the bit error detection indicators and the read event and multi event flags may be referred to as ECC circuitry. For example, referring to FIG. 3, the circuitry located outside of isolation switches 305 and differential read-out circuit 302 may be part of the ECC circuitry.

It can be seen how, for a read access to array 102, the use of the parity result (which requires only a single parity bit for the accessed data element) in addition to the read event and multi event flags, can be used to provide SECDED ECC but without requiring the use of multiple corrections (e.g. syndrome) bits, as is needed for traditional SECDED ECC. For example, for traditional SECDED ECC for a 16-bit data element, 6 correction bits are required. Therefore, each row of array 102 would have to store 22 bits (16+6) rather than only 17 bits (16+1) as in the illustrated embodiments above. That is, rather than requiring storage for an additional 6 bits of corrections bits to perform SECDED ECC, only 1 additional bit needs to be stored (a parity bit) to perform the functionality of SECDED ECC. Further, for each read access for the traditional SECDED ECC, a bus width of 22 bits (16+6) is required, but, in the embodiments above, a bus width of only 19 bits is required, thus reducing the required width of the read bus.

It can be understood how the reduced area storage (and reduced bus width) can be achieved by using a memory array having differential bit cells for storing data elements and their corresponding parity bit, in which, during each read operation to the array, accessing both the differential data and single-ended data (which may be performed in parallel or in series with each other), such that ECC circuitry can use the single-ended reads to detect and indicate a single bit error or multiple bit error for the read operation and use the differential data to correct a single bit error, if possible. In this manner, an NVM with ECC is provided with reduced area overhead and reduced complexity.

As used herein, the term "bus" is used to refer to a plurality of signals or conductors which may be used to transfer one or more various types of information, such as data, addresses, control, or status. The conductors as discussed herein may be illustrated or described in reference to being a single conductor, a plurality of conductors, unidirectional conductors, or bidirectional conductors. However, different embodiments may vary the implementation of the conductors. For example, separate unidirectional conductors may be used rather than bidirectional conductors and vice versa. Also, plurality of conductors may be replaced with a single conductor that transfers multiple signals serially or in a time multiplexed manner. Likewise, single conductors carrying multiple signals may be separated out into various different conductors carrying subsets of these signals. Therefore, many options exist for transferring signals.

The terms "assert" or "set" and "negate" (or "deassert" or "clear") are used herein when referring to the rendering of a signal, status bit, or similar apparatus into its logically true or logically false state, respectively. If the logically true state is a logic level one, the logically false state is a logic level zero. And if the logically true state is a logic level zero, the logically false state is a logic level one.

Each signal described herein may be designed as positive or negative logic, where negative logic can be indicated by a bar over the signal name or an asterisk (*) following the name. In the case of a negative logic signal, the signal is active low where the logically true state corresponds to a logic level zero. In the case of a positive logic signal, the signal is active high where the logically true state corresponds to a logic level one. Note that any of the signals described herein can be designed as either negative or positive logic signals. Therefore, in alternate embodiments, those signals described as positive logic signals may be implemented as negative logic signals, and those signals described as negative logic signals may be implemented as positive logic signals.

Brackets are used herein to indicate the conductors of a bus or the bit locations of a value. For example, "bus 60 [7:0]" or "conductors [7:0] of bus 60" indicates the eight lower order conductors of bus 60, and "address bits [7:0]" or "ADDRESS [7:0]" indicates the eight lower order bits of an address value. The symbol "$" preceding a number indicates that the number is represented in its hexadecimal or base sixteen form. The symbol "%" preceding a number indicates that the number is represented in its binary or base two form.

Because the apparatus implementing the present invention is, for the most part, composed of electronic components and circuits known to those skilled in the art, circuit details will not be explained in any greater extent than that considered necessary as illustrated above, for the understanding and appreciation of the underlying concepts of the present invention and in order not to obfuscate or distract from the teachings of the present invention.

Although the invention has been described with respect to specific conductivity types or polarity of potentials, skilled artisans appreciated that conductivity types and polarities of potentials may be reversed.

Moreover, the terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Some of the above embodiments, as applicable, may be implemented using a variety of different information processing systems. For example, although FIG. 1 and the discussion thereof describe an exemplary information processing architecture, this exemplary architecture is presented merely to provide a useful reference in discussing various aspects of the invention. Of course, the description of the architecture has been simplified for purposes of discussion, and it is just one of many different types of appropriate architectures that may be used in accordance with the invention. Those skilled in the art will recognize that the boundaries between logic blocks are merely illustrative and that alternative embodiments may merge logic blocks or circuit elements or impose an alternate decomposition of functionality upon various logic blocks or circuit elements. Thus, it is to be understood that the architectures depicted herein are merely exemplary, and that in fact many other architectures can be implemented which achieve the same functionality.

Also for example, in one embodiment, the illustrated elements of system 100 are circuitry located on a single integrated circuit or within a same device. Alternatively, system 100 may include any number of separate integrated circuits or separate devices interconnected with each other. Also, in one embodiment, memory system 100 may be integrated into a larger system, such as an SoC.

Furthermore, those skilled in the art will recognize that boundaries between the functionality of the above described operations merely illustrative. The functionality of multiple operations may be combined into a single operation, and/or the functionality of a single operation may be distributed in additional operations. Moreover, alternative embodiments may include multiple instances of a particular operation, and the order of operations may be altered in various other embodiments.

Although the invention is described herein with reference to specific embodiments, various modifications and changes can be made without departing from the scope of the present invention as set forth in the claims below. For example, different types of storage elements may be used for each differential bit, and different combinations and configurations of logic gates can be used to implement the functionality of the digital logic within the ECC circuitry (of, e.g., bit error detection circuit 310, XOR gate 312, OR gates 316 and 318, and AND gate 314). Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

The term "coupled," as used herein, is not intended to be limited to a direct coupling or a mechanical coupling.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

The following are various embodiments of the present invention. Note that any of the aspects below can be used in any combination with each other and with any of the disclosed embodiments.

In an embodiment, a non-volatile memory (NVM) includes a memory array arranged in rows and columns and having a differential bit cell at each row and column intersection, wherein each row is configured to store an N-bit data element and a single parity bit corresponding to the data element, and each differential bit cell includes a first single-ended bit cell having a storage element configured to store a logic state of the first single-ended bit cell, and a second single-ended bit cell having a storage element configured to store a logic state of the second single-ended bit cell, wherein a logic state of the differential bit cell is determined by the logic states of the first and second single-ended bit cells. The NVM also includes read circuitry configured to, in response to a read access request, perform a read operation from differential bit cells of a selected row of the memory array, wherein performing the read operation includes providing, from the differential bit cells of the selected row, differential read data having an N-bit data value and a corresponding single bit parity value, providing logic states of each of the first and second single-ended bit cells of the differential bit cells of the selected row, and generating, based on the logic states of the first and second single-ended bit cells of the differential bit cells, a read event flag and a multiple event flag for the read operation. In one aspect, the read event flag is asserted for the read operation when the logic circuitry detects at least one single ended error, and the multiple event flag is asserted for the read operation when the logic circuitry detects more than one single ended error. In a further aspect, each column of the array includes a corresponding bit line pair, wherein, for each column of the memory array, the read circuitry includes a differential read-out circuit coupled to the corresponding bit line pair and configured to provide a corresponding differential bit value, a first single-ended read-out circuit coupled to one bit line of the corresponding bit line pair, and configured to provide a corresponding first single-ended read value, a second single-ended read-out circuit coupled to another bit line of the corresponding bit line pair, and configured to provide a corresponding second single-ended read value, and a bit error detection circuit configured to provide a corresponding bit error detection indicator based on the first and second single-ended read values, wherein the bit error detection circuit is configured to assert the corresponding bit error detection indicator when a corresponding single-ended error is indicated. In yet a further aspect, the corresponding single-ended error is indicated when the corresponding first single-ended read value matches the corresponding second single-ended read value. In another yet further aspect, the read circuitry further includes logic circuitry configured to generate the read event flag for the read operation based on the corresponding bit error detection indicators for the columns of the memory array. In yet an even further aspect, the read event flag for the read operation is generated as a logical OR of the corresponding bit error detection indicators. In another even further aspect, logic circuitry is further configured to generate a corresponding corrected differential bit value based the corresponding differential bit value and the corresponding bit error detection indicator. In another even further aspect, the logic circuitry is further configured to generate the multiple event flag for the read operation based on the corresponding bit error detection indicator of multiple columns. In another aspect of the embodiment, the providing the logic states of each of the first and second single-ended bit cells of the differential bit cells of the selected row includes providing an ((N+1)x2)-bit single-ended read value. In another aspect, the providing the differential read data and the providing the logic states are performed in parallel.

In another embodiment, a non-volatile memory (NVM) includes a memory array arranged in rows and columns and having a differential bit cell at each row and column intersection, wherein each differential bit cell is coupled to a corresponding bit line pair, and each row is configured to store a data element and a single parity bit corresponding to the data element, and each differential bit cell includes a first single-ended bit cell coupled to one bit line of the corresponding bit line pair and having a storage element configured to store a logic state of the first single-ended bit cell, and a second single-ended bit cell coupled to another bit line of the corresponding bit line pair and having a storage element configured to store a logic state of the second single-ended bit cell. The NVM further includes read circuitry including, for each column of the memory array, a differential read-out circuit configured to provide a corresponding differential bit value of a differential read value from differential bit cells of a selected row of the memory array, a first single-ended read-out circuit configured to provide a corresponding first single-ended bit value of a single-ended read value from the differential bit cells of the selected row, a second single-ended read-out circuit configured to provide a corresponding second single-ended bit value of the single-ended read value from the differential cells of the selected row, and logic circuitry configured to generate, based on the single-ended read value, a read event flag and a multiple event flag corresponding to the differential read value. In one aspect of the another embodiment, the differential read value includes an N-bit data value and a corresponding single parity bit value, and the single-ended read value includes (N+1)x2 bits. In another aspect, for each column of the memory array, the logic circuitry includes a bit error detection circuit configured to provide a corresponding bit error detection indicator based on the corresponding first and second single-ended read values, wherein the bit error detection circuit is configured to assert the corresponding bit error detection indicator when a corresponding single-ended error is indicated. In a further aspect, the corresponding single-ended error is indicated when the corresponding first single-ended read value matches the corresponding second single-ended read value. In another aspect, the read event flag is asserted for the differential read value when the logic circuitry detects at least one single ended error, and the multiple event flag is asserted for the differential read value when the logic circuitry detects more than one single ended error. In a further aspect, the read event flag is generated as a logical OR of the corresponding bit error detection indicators. In another further aspect, for each column of the memory array, the logic circuitry is further configured to generate a corresponding corrected differential bit value based the corresponding differential bit value and the corresponding bit error detection indicator.

In yet another embodiment, a method of operating a non-volatile memory (NVM) having a memory array arranged in row and columns and having a differential bit cell at each row and column intersection, wherein each differential bit cell includes a corresponding first single-ended bit cell having a storage element configured to store a logic state of the corresponding first single-ended bit cell a corresponding second single-ended bit cell having a storage element configured to store a logic state of the corresponding second single-ended bit cell, in which a logic state of the differential cell is determined by the logic states of the corresponding first and second single-ended bit cells, includes receiving a read access request addressing a selected set of differential bit cells of the memory array; and performing a read operation in response to the read access request. The read operation includes providing, from the selected set of differential bit cells, differential read data having an N-bit data value and a corresponding single bit parity value, providing single-ended read data having (N+1)x2 bits by providing bit values from each of the corresponding first and corresponding second single-ended bit cells of the selected set of differential bit cells, and providing, based on the bit values from the corresponding first and corresponding second single-ended bit cells of the selected set of differential bit cells, a read event flag and a multiple event flag for the read operation, wherein the read event flag is asserted for the read operation when the logic circuitry detects at least one single ended error, and the multiple event flag is asserted for the read operation when the logic circuitry detects more than one single ended error. In one aspect of the yet another embodiment, the providing the read event flag for the read operation further includes generating a corresponding bit error detection indicator for each differential bit cell of the selected set of differential bit cells by determining whether or not the bit values from each of the corresponding first and corresponding second single-ended bit cells match, wherein the read event flag is generated based on the corresponding bit error detection indicators for the selected set of differential bit cells. In a further aspect, the read operation further includes generating a corresponding corrected differential bit value for each bit of the differential read data based on the bit of the differential read value and the corresponding bit error detection indicator.

## Claims

1. A non-volatile memory (NVM), comprising:
a memory array arranged in rows and columns and having a differential bit cell at each row and column intersection, wherein each row is configured to store an N-bit data element and a single parity bit corresponding to the data element, and each differential bit cell includes:
a first single-ended bit cell having a storage element configured to store a logic state of the first single-ended bit cell, and
a second single-ended bit cell having a storage element configured to store a logic state of the second single-ended bit cell, wherein a logic state of the differential bit cell is determined by the logic states of the first and second single-ended bit cells; and
read circuitry configured to, in response to a read access request, perform a read operation from differential bit cells of a selected row of the memory array, wherein performing the read operation includes:
providing, from the differential bit cells of the selected row, differential read data having an N-bit data value and a corresponding single bit parity value,
providing logic states of each of the first and second single-ended bit cells of the differential bit cells of the selected row, and
generating, based on the logic states of the first and second single-ended bit cells of the differential bit cells, a read event flag and a multiple event flag for the read operation.

2. The NVM of claim 1, wherein:
the read event flag is asserted for the read operation when the logic circuitry detects at least one single ended error, and
the multiple event flag is asserted for the read operation when the logic circuitry detects more than one single ended error.

3. The NVM of claim 2, wherein each column of the array comprises a corresponding bit line pair, wherein, for each column of the memory array, the read circuitry comprises:
a differential read-out circuit coupled to the corresponding bit line pair and configured to provide a corresponding differential bit value,
a first single-ended read-out circuit coupled to one bit line of the corresponding bit line pair, and configured to provide a corresponding first single-ended read value,
a second single-ended read-out circuit coupled to another bit line of the corresponding bit line pair, and configured to provide a corresponding second single-ended read value, and
a bit error detection circuit configured to provide a corresponding bit error detection indicator based on the first and second single-ended read values, wherein the bit error detection circuit is configured to assert the corresponding bit error detection indicator when a corresponding single-ended error is indicated.

4. The NVM of claim 3, wherein the corresponding single-ended error is indicated when the corresponding first single-ended read value matches the corresponding second single-ended read value.

5. The NVM of claim 3 or 4, wherein the read circuitry further comprises logic circuitry configured to generate the read event flag for the read operation based on the corresponding bit error detection indicators for the columns of the memory array.

6. The NVM of claim 5, wherein the read event flag for the read operation is generated as a logical OR of the corresponding bit error detection indicators.

7. The NVM of claim 5 or 6, wherein the logic circuitry is further configured to generate a corresponding corrected differential bit value based the corresponding differential bit value and the corresponding bit error detection indicator.

8. The NVM of any one of claims 5 to 7, wherein the logic circuitry is further configured to generate the multiple event flag for the read operation based on the corresponding bit error detection indicator of multiple columns.

9. The NVM of any preceding claim, wherein the providing the logic states of each of the first and second single-ended bit cells of the differential bit cells of the selected row comprises providing an ((N+1)x2)-bit single-ended read value.

10. The NVM of any preceding claim, wherein the providing the differential read data and the providing the logic states are performed in parallel.

11. A method of operating a non-volatile memory (NVM), the NVM having a memory array arranged in row and columns and having a differential bit cell at each row and column intersection, wherein each differential bit cell includes a corresponding first single-ended bit cell having a storage element configured to store a logic state of the corresponding first single-ended bit cell a corresponding second single-ended bit cell having a storage element configured to store a logic state of the corresponding second single-ended bit cell, in which a logic state of the differential cell is determined by the logic states of the corresponding first and second single-ended bit cells, the method comprising:
receiving a read access request addressing a selected set of differential bit cells of the memory array; and
performing a read operation in response to the read access request, wherein the read operation comprises:
providing, from the selected set of differential bit cells, differential read data having an N-bit data value and a corresponding single bit parity value,
providing single-ended read data having (N+1)x2 bits by providing bit values from each of the corresponding first and corresponding second single-ended bit cells of the selected set of differential bit cells, and
providing, based on the bit values from the corresponding first and corresponding second single-ended bit cells of the selected set of differential bit cells, a read event flag and a multiple event flag for the read operation, wherein:
the read event flag is asserted for the read operation when the logic circuitry detects at least one single ended error, and
the multiple event flag is asserted for the read operation when the logic circuitry detects more than one single ended error.

12. The method of claim 11, wherein the providing the read event flag for the read operation further comprises:
generating a corresponding bit error detection indicator for each differential bit cell of the selected set of differential bit cells by determining whether or not the bit values from each of the corresponding first and corresponding second single-ended bit cells match, wherein the read event flag is generated based on the corresponding bit error detection indicators for the selected set of differential bit cells.

13. The NVM of claim 12, wherein the read operation further comprises:
generating a corresponding corrected differential bit value for each bit of the differential read data based on the bit of the differential read value and the corresponding bit error detection indicator.
